# EUROPEAN PATENT APPLICATION

(11) **EP 2 040 296 A2**
(43) Date of publication of application: **25.03.2009**
(21) Application number: 08164294.4
(22) Date of filing: 12.09.2008
(51) Int. Cl.: H01L 23/498

(54) **Method for forming BGA package with increased standoff height**

(30) Priority: 24.09.2007 US 903570
(71) Applicant: Delphi Technologies, Inc., Troy, Michigan 48007 (US)
(72) Inventor: Webster, Mark E., Kokomo, IN 46902 (US); Parker, Richard D., Tipton, IN 46072 (US)
(74) Representative: Denton, Michael John

(57) **Abstract**

A method of forming a Ball Grid Array (BGA) package having an increased standoff height after solder reflow is described. A substrate containing a plurality of first solder bond pads and a component containing a plurality of second solder bond pads are arranged in parallel spaced relationship to form an arrangement, each first and second bond pad being in contact with a solder ball therebetween. Solder balls are formed of a core, which remains solid at solder reflow temperatures, encapsulated with a reflowable solder layer. First standoff height of the arrangement is largely determined by the diameter of the solder ball. Upon heating to solder reflow temperatures, the solder coalesces between the core and the bond pads. Upon cooling of the arrangement, the second standoff height of the BGA package is greater than the first standoff height of the arrangement.

## Description

### TECHNICAL FIELD

This invention relates to a method of forming a Ball Grid Array (BGA) package having increased standoff height. More particularly, this invention relates to a method that uses solder balls comprising a core formed of polymeric material or the like to form solder bump interconnections that increase the standoff height.

### BACKGROUND OF INVENTION

It is known to form a ball grid array package comprising an electronic assembly mounted to a substrate by solder bump interconnections. For example, an assembly with an encapsulated integrated circuit die may be mounted onto a mother board by solder bump interconnections. The substrate and assembly are parallel and spaced apart by a gap, with the solder bump interconnections disposed within the gap. The solder bump interconnections electrically and physically attach the substrate to the assembly via bond pads on the substrate and assembly. It has been proposed to form the interconnections using solder balls that include a polymeric core with a solder layer. The balls are placed on the pads, the substrate and assembly are aligned with the balls in between and then heated to reflow the solder. The core serves as spacer to assure minimal distance between the substrate and assembly.

During operation, the solder bump interconnections may crack due to stresses induced by thermal expansion mismatch between the assembly and the substrate, severing the electrical connection between the electronic assembly and the substrate and causing failure of the package. The distance between the surface of the substrate and the surface of the electronic assembly is referred to as the standoff height. Increasing the standoff height reduces the stresses and creates a more reliable connection. Further, it is known to locate electrical components on the substrate below the electronic assembly. The components generate heat. Increasing the standoff height between the substrate and the assembly enhances the flow of air or other cooling fluid within the gap and improves cooling of the electrical components underlying the assembly.

Accordingly, it is desired to form a package comprising an electronic assembly attached to a substrate by solder bump interconnections, wherein the standoff height between the assembly and the substrate is increased, thereby reducing stress on the interconnections and enhancing coolant flow within the space between the assembly and the substrate.

### SUMMARY OF THE INVENTION

In accordance with this invention, a method is provided for forming a Ball Grid Array package having increased standoff height. A substrate is provided which includes a plurality of first solder bond pads. A solder ball is disposed onto each first solder bond pad. The solder ball is formed of a core, made of a material that remains solid at solder reflow temperature, and is encapsulated within a reflowable solder layer. An electronic assembly is arranged overlying the substrate such that second bond pads on the assembly are in contact with solder balls, thereby forming an arrangement wherein the substrate and the assembly are in a parallel, spaced relationship with solder balls in between the first and second bond pads and is characterized by a first standoff height between the substrate and the assembly. The arrangement is heated to a temperature for a time effective to melt and reflow the solder. The molten solder wets the first and second bond pads and coalesces between the solid core and at least one of the bond pads to increase the standoff height. Upon cooling and solidification of the solder, the ball grid array package is characterized by a second standoff height greater than the first standoff height of the pre-reflow arrangement.

Further features and advantages of the invention will appear more clearly on a reading of the following detailed description of the preferred embodiment of the invention, which is given by way of non-limiting example only and with reference to the accompanying drawings.

### BRIEF DESCRIPTION OF DRAWINGS

This invention will be further described with reference to the accompanying drawings in which:

Fig. 1 is a cross-section of an arrangement for forming a ball grid array package in accordance with this invention.

Fig. 2 is a cross-section of a portion of the arrangement in Fig. 1 showing details of the solder ball.

Fig. 3 is a cross-section of the BGA package formed by the arrangement in Fig. 1.

Fig. 4 is a cross-section of a portion of the BGA package in Fig. 3 showing details of the solder bump interconnection.

### DESCRIPTION OF THE PREFERRED EMBODIMENTS

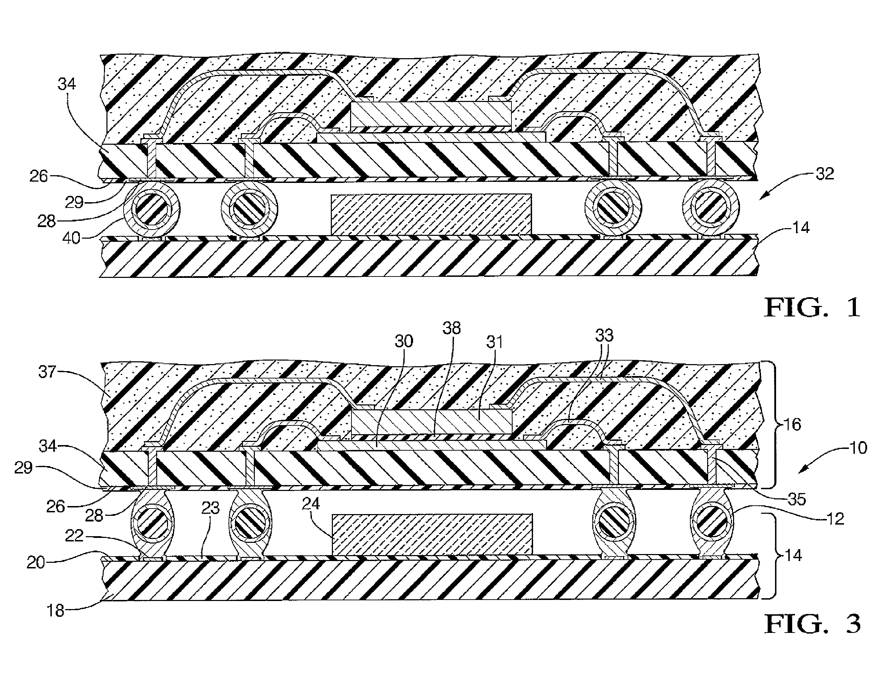

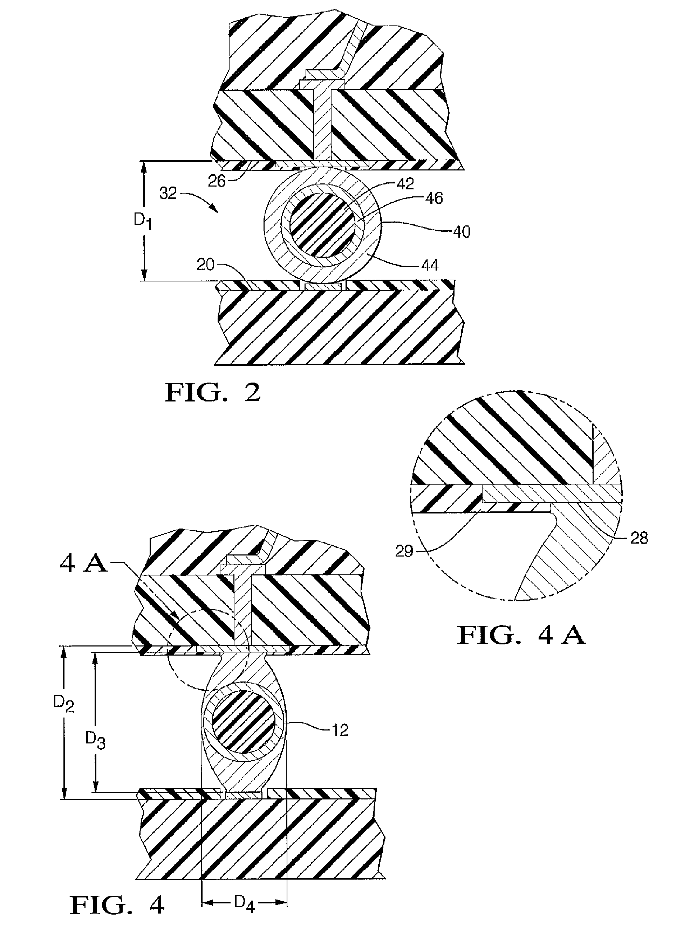

In accordance with a preferred embodiment of this invention, a method is provided for forming a ball grid array (BGA) package 10 in Figs. 3 and 4 having increased standoff height. Package 10 includes solder bump interconnections 12 attaching a substrate 14 to an electronic assembly 16. Interconnections 12 connect a metallic trace on the substrate 14 to a circuit trace on the assembly 16 to not only physically attach the assembly 16 to the substrate 14, but also to electrically connect the circuit on the assembly 16 to the circuit on the substrate 14.

Substrate 14 preferably includes a board 18 formed of a polymeric or ceramic material and having a surface 20. A metallic trace is disposed on the surface and includes first bond pads 22. A solder resist layer 23 covers surface 20 and is patterned to create an opening that exposes first bond pads 22. A preferred substrate may be an FR-4 board. While in this embodiment the package includes a single substrate, the substrate may in turn be connected to one or more additional substrates to form product comprising multiple BGA packages, commonly referred to as a package-on-package (PoP) product. In this embodiment, substrate 14 also includes an electrical component 24 mounted to surface 20 of board 18 and underlying electronic assembly 16. Component 24 is spaced apart from electronic assembly 16 to allow coolant flow for heat dissipation of heat generated by component 24 during operation. A preferred component is a capacitor.

Electronic assembly 16 comprises a carrier 34 composed of polymeric or ceramic material and having a surface 26 facing the substrate. A metallic trace is disposed on surface 26 and includes second bond pads 28, in registration with first bond pads 22. A solder resist layer 29 covers surface 26 and is patterned to create an opening that exposes second bond pads 28. Electronic assembly 16 comprises a microelectronic die 30 and a component 31, spaced apart by insulator 38, and mounted to carrier 34 opposite surface 26. Microelectronic die and component are electrically connected to carrier 34 using wire bonds 33, which are in turn connected to second bond pads 28 using metal vias 35 through carrier 34. The microelectronic die 30 and component 31 are encapsulated by a polymeric overmolding 37 to protect the die and wire bonds during use.

Referring now to Figs. 1 and 2, there is shown an arrangement 32 for forming package 10. Arrangement 32 comprises carrier 34 having a carrier surface 26 and a plurality of second bond pads 28 disposed on the carrier surface. Solder resist 29 covers carrier surface 26, exposing second bond pads 28. Each second bond pad 28 is in contact with a solder ball 40, thereby forming an arrangement 32 comprising the carrier 34 and the substrate 14 arranged in a parallel, spaced relationship. Arrangement 32 is characterized by a first standoff distance D1 between the carrier surface 26 and the substrate surface 20, substantially determined by the solder ball diameter. Alternately, the standoff height may be measured between the surface of solder resist layer 23 and the surface of solder resist layer 29, since the surfaces are generally planar and the thicknesses of the solder layers are small. Solder ball 40 comprises a core 42, a solder layer 44 encapsulating the core, and a solder wettable layer 46 disposed between core 42 and solder layer 44. In a preferred embodiment, solder layer 44 is formed of a near eutectic alloy containing 63% tin and the balance lead. In the described embodiment, core 42 is formed of a polymeric material, preferably a di-vinylbenzene co-polymer. Alternately, the core may be formed of any suitable material that remains solid at solder reflow temperatures. Layer 46 is formed of a metal that is wet by molten solder. Suitable metals include copper or copper alloys, or nickel or nickel alloys. Suitable solder balls are commercially available from Indium Corporation under the trade designation Indium Sphereot.

After the substrate 14, electronic assembly 16, and solder balls 40 are arranged as depicted in Figs. 1 and 2, the arrangement 32 is heated to a temperature of about 210°C for a time of about 30 seconds, effective to reflow the solder. During solder reflow the solder liquefies and wets the first bond pad 22 and the second bond pad 28, at the openings in solder resist layers 23 and 29, respectively. In the depicted embodiment, the width of the first bond pad 22 is approximately 75 per cent of the diameter of the solder ball core 42. The solder resist layer 23 is patterned to create an opening that exposes first bond pad 22, allowing the top and side surfaces of the bond pad to be wet with molten solder. In this embodiment, second bond pad 28 is also narrower than the solder ball core 42. For this purpose, the bond pad is defined as the metal exposed by the opening in the solder resist layer, to which the solder wets and bonds during reflow. Upon cooling, the solder resolidifies and bonds to the bond pads to form the solder bump interconnections 12.

Upon examination of the solder bump interconnections 12, it is found that the solder coalesces between core 42 and bond pad 22 and also between core 42 and bond pad 28, to increase the distance between the first bond pad 22 and the second bond pad 28, as shown in Figs. 3 and 4. As a result, the package exhibits a second standoff distance D2, between the substrate surface 20 and the carrier surface 26, which is greater than the first standoff distance D1 shown in Figs. 1-2. In a preferred embodiment, the second standoff distance D2 is at least 10 per cent greater and may be at least 25 per cent greater than the first standoff distance D1.

While not wishing to be limited to any particular theory, it is believed that molten solder surrounding the core of the solder ball tends to be drawn toward the bond pads during reflow as a result of the solder wetting the metal of the bond pads. When the size of the bond pad limits the spread of the solder, the solder coalesces between the core and the bond pads, increasing the distance between the core and the bond pad and thus the standoff height of the package. In accordance with this invention, it is believed that sizing the bond pad less than the diameter of the core is effective to increase the standoff height of the package. Preferably, the width of the bond pad is less than about 75 percent of the diameter of the core of the composite solder ball. In the described embodiment, both bond pads are sized to limit the spread of the solder. This process results in a solder bump interconnection characterized by a columnar shape. Referring to Fig. 4, interconnections 12 are characterized by a dimension D3 between first bond pad 22 and second bond pad 28 perpendicular to board surface 20 that is greater than a cross sectional dimension D4 through the core center parallel to substrate surface. As a result, interconnections formed in accordance with this invention increase the standoff distance D2 between the assembly and the substrate. The increase in the standoff height is preferably at least 10 percent, and more preferably at least 25 percent, relative to the standoff height exhibited in the arrangement prior to reflow.

Thus, this invention provides a method for forming a ball grid array package with increased standoff distance. During operation, BGA packages may be subjected to thermal cycling caused by normal operation of electronic components mounted on the carrier and substrate. The heat from these components generates stress on the solder bump interconnections between the substrate and the carrier due to thermal expansion mismatch. The stress may lead to cracks in the solder bump interconnection, severing the electrical connection and causing failure of the BGA package. Increasing the standoff distance in BGA array reduces the stress on the solder bump interconnections, resulting in a more reliable package.

Some components in the BGA package may require active cooling while in operation. Active cooling of components in a BGA package may be achieved by passing air or other coolant over the component to enable heat transfer from the component to the coolant. Increasing the standoff distance in the BGA array allows for more air or other coolant to pass by the component, increasing the efficiency of the cooling process, and ultimately resulting in a more reliable package.

While this invention has been described in terms of the preferred embodiments thereof, it is not intended to be so limited, but rather only to the extent set forth in the claims that follow.

## Claims

1. A method for forming a ball grid array package comprising the steps of:
providing a substrate having a substrate surface and a plurality of first solder bond pads disposed on the substrate surface;
disposing a solder ball onto each first solder bond pad, said solder ball comprising a core encapsulated within a reflowable solder layer and having a solder ball diameter, said reflowable solder layer being formed of a solder having a solder reflow temperature, said core being formed of a material that remains solid at the solder reflow temperature;
arranging an electronic assembly overlying the substrate, said assembly comprising a carrier having a carrier surface and a plurality of second bond pads disposed on the carrier surface, each said second bond pad being in contact with a solder ball, thereby forming an arrangement comprising said substrate and said assembly in parallel, spaced relationship with said substrate surface facing the carrier surface and said solder balls therebetween, said arrangement being **characterized by** a first standoff height between the substrate surface and the carrier surface;
heating the arrangement to a temperature and for a time effective to reflow the solder, whereupon molten solder wets the first and second bond pads and coalesces between the core and at least one of said first and second bond pads to increase the distance between the first and second bond pads; and
cooling the arrangement to resolidify the solder to form solder bump interconnections bonded to the first and second bond pads and to form the ball grid array package, said ball grid array package being **characterized by** a second standoff height between the substrate surface and the carrier surface greater than the first standoff height.

2. The method in accordance with claim 1, wherein the first and second bond pads are arranged about the solder ball during heating, whereby capillary flow causes molten solder to coalesce adjacent at least one bond pad during reflow.

3. The method in accordance with claim 1, wherein the solder ball core is formed of a polymeric material.

4. The method in accordance with claim 3, wherein the polymeric material is di-vinylbenzene co-polymer.

5. The method in accordance with claim 3, wherein the solder ball comprises a polymeric core, a metallic layer coating the core and composed of a metal wettable by molten solder, and a solder layer coating the metallic layer.

6. The method in accordance with claim 3, wherein the solder ball comprises a polymeric core, a solder wettable layer coating the core and a solder layer coating the solder wettable layer.

7. The method in accordance with claim 3, wherein the solder wettable layer is formed of a metal selected from the group consisting of copper, nickel and alloys of copper or nickel.

8. The method in accordance with claim 1, wherein the solder bump interconnection is **characterized by** a dimension parallel to the substrate less than the solder ball diameter.

9. The method in accordance with claim 1, wherein the second standoff height is at least 10 per cent greater than the first standoff height.

10. The method in accordance with claim 1, wherein the second standoff height is at least 25 per cent greater than the first standoff height.

11. A method for forming a ball grid array package comprising the steps of:
providing a substrate comprising a plurality of first solder bond pads;
disposing a solder ball onto each first solder bond pad, said solder ball comprising a polymeric core encapsulated within a reflowable solder layer and having a solder ball diameter, said solder layer being formed of a solder alloy composed of tin and lead;
arranging an electronic assembly overlying the substrate, said assembly comprising a carrier having a carrier surface and a plurality of second bond pads disposed on the carrier surface, each said second bond pad being in contact with a solder ball, thereby forming an arrangement comprising said substrate and said assembly in parallel, spaced relationship with said solder balls therebetween, said arrangement being **characterized by** a first standoff height between the first bond pad and the second bond pad equal to the solder ball diameter;
heating the arrangement to a temperature and for a time effective to reflow the solder alloy, whereupon molten solder wets the first and second bond pads and coalesces between the core and at least one of said first and second bond pads to increase the distance between the first and second bond pads; and
cooling the arrangement to resolidify the solder alloy to form solder bump interconnections bonded to the first and second bond pads and thereby form the ball grid array package, said ball grid array package being **characterized by** a second standoff height at least 25 per cent greater than the first standoff height.

12. A ball grid array package comprising:
a substrate comprising a board having a board surface that is planar and a plurality of first bond pads disposed on the surface;
a electronic assembly overlying the substrate, said electronic assembly comprising a carrier having a carrier surface facing the substrate and a plurality of second bond pads disposed on the surface; and
a plurality of solder bump interconnections, each solder bump interconnection connecting a first bond pad and a second bond pad, each said solder bump interconnection comprising a core having a center and a solder layer encapsulating the core and bonded to the bond pads, said solder bump interconnection being **characterized by** a columnar shape having a dimension between first bond pad and second bond pad perpendicular to the board surface greater than a cross sectional dimension through the core center parallel to the substrate surface.

13. A ball grid array in accordance with claim 11, wherein the core is a sphereical core.

14. A ball grid array in accordance with claim 11, wherein the solder layer is formed of a solder alloy having a reflow temperature, and wherein the core is formed of a material that remains solid at the solder reflow temperature.

15. A ball grid array in accordance with claim 13, wherein the core is formed of a polymeric material.

16. A ball grid array in accordance with claim 11, wherein the solder bump interconnection includes a solder wettable layer coating the core and formed of a metal selected from the group consisting of copper, nickel and alloys comprising copper or nickel.

17. A ball grid array package comprising
a substrate comprising a board having a board surface that is planar and a plurality of first bond pads disposed on the surface;
a electronic assembly overlying the substrate, said electronic assembly comprising a carrier having a carrier surface facing the substrate in parallel, spaced relationship and a plurality of second bond pads disposed on the surface; and
a plurality of solder bump interconnections, each solder bump interconnection connecting a first bond pad and a second bond pad, each said solder bump interconnection comprising a core, a solder layer encapsulating the core and bonded to the bond pads, and a solder wettable layer disposed between the core and the solder layer, said core being spherical shape having a center and composed of a polymeric material, said solder bump interconnection being **characterized by** a columnar shape having a dimension between first bond pad and second bond pad perpendicular to the board surface greater than a cross sectional dimension though the core center parallel to the substrate surface.
